# EUROPEAN PATENT SPECIFICATION

(11) **EP 0 211 385 B1**
(45) Date of publication and mention of the grant of the patent: **17.03.1993**
(21) Application number: 86110494.1
(22) Date of filing: 30.07.1986
(51) Int. Cl.: G11C 8/04, G11C 19/00

(54) **Memory device**
Speicheranordnung
Dispositif de mémoire

(30) Priority: 30.07.1985 JP 168027/85
(43) Date of publication of application: 25.02.1987
(60) Divisional application: 91114289.1
(73) Proprietor: KABUSHIKI KAISHA TOSHIBA, Kawasaki-shi, Kanagawa-ken 210 (JP)
(72) Inventor: Sumi, Masahiko, Chigasaki-shi Kanagawa-ken (JP)
(74) Representative: Lehn, Werner, Dipl.-Ing.

(56) References cited:
- EP-A- 0 155 731
- WO-A-85/02935
- US-A- 4 395 764
- US-A- 4 509 142

## Description

### BACKGROUND OF THE INVENTION

The present invention relates to a memory device, and more particularly to a memory device basically identical to that of a shift register having a variable depth of stages.

Shift registers comprising a plurality of registers cascade-connected to shift their contents in sequence play an important role in computational processings or image processings, etc. Products having various capacities of 4,8,16, 1024 and 64K bits, etc. have been available.

US-A-4 395 764 shows a device having addressing means, cyclically changing, and two memory blocks, all arranged to read and write data in one clock cycle as a shift register of variable depth. WO 85/02935 shows a RAM device arranged as a shift register having a counter supplying addresses.

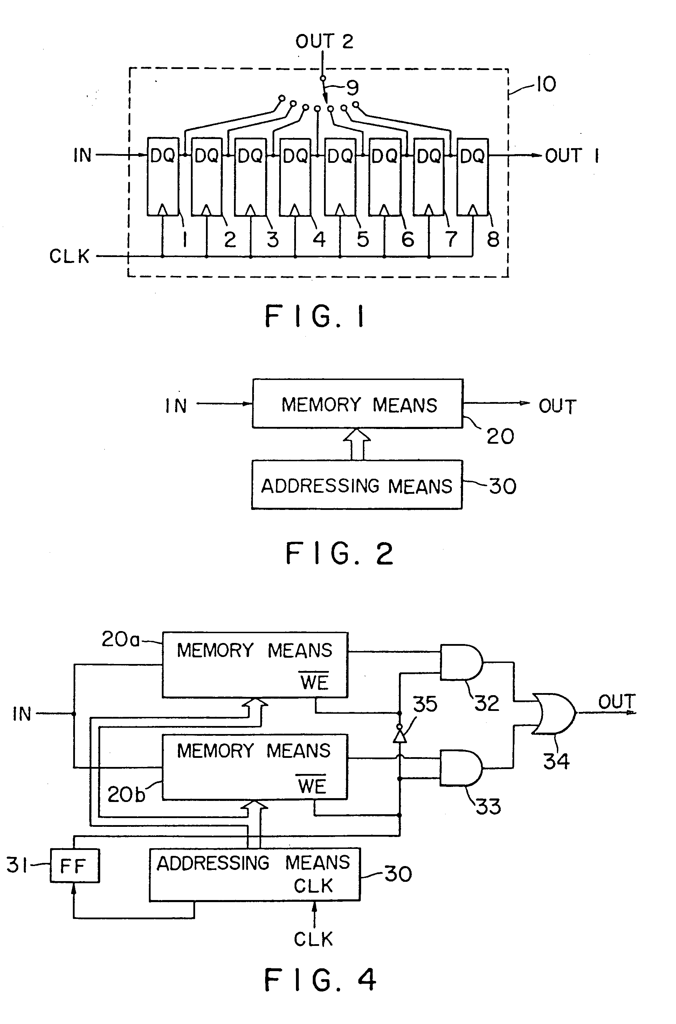

Referring to Fig. 1, there is shown an example of a commonly used conventional shift register 10 of 8 bit configuration. This shift register 10 comprises eight stages of flip-flops 1 to 8 wherein Q outputs of the flip-flops are respectively connected to D inputs of the next stages thereof and a clock line is commonly connected to the respective flip-flops.

With the shift register thus configured, when a clock pulse signal is input from the clock line CLK, data input to the leftmost flip-flop 1 is transferred one stage to the right per each clock pulse and output data is fetched from an output terminal OUT 1 of the rightmost flip-flop 8.

To change the number of stages in the shift register 10 of the eight stages, as shown in Fig. 1, a method has been employed to provide lead-out or draw-out lines on the number of stages, its realization is impossible in an actual sense.

For instance, when characters or figures (graphic pattern) are displayed on a CRT using a display device, there is employed a method to store display information in a storage unit to use the information read for a required display. When there is no change in information corresponding to one frame (frame information), it is convenient to repeatedly read the display information at a rate of 60 per second. Generally, a volume of such an information corresponding to one frame is not necessarily expressed by the second power (power of 2) and the frame information requires a large capacity. Hitherto, for storing such a frame information, it was necessary to specially provide a storage unit having a required memory capacity, resulting in high cost of the device. In addition, in the case of the above-mentioned example, since all of the memory capacity of the second power are not used, there occurs a wasteful memory capacity and an operation for combining valid or effective informations with each other is required.

### SUMMARY OF THE INVENTION

All object of the present invention is to provide a memory device having an arbitrary number of stages.

Another object of the present invention is to provide a memory device having an arbitrary number of stages and capable of outputting the same value every single-cyclic clock signal.

A further object of the present invention is to provide a memory device having an arbitrary number of stages and capable of changing memory contents according to need.

A still further object of the present invention is to provide a memory device having an arbitrary depth of 2N stages using a double-cyclic N clock signal.

According to the present invention there is provided a memory device comprising:
a) addressing means for cyclically designating different values as addresses for input and output of data per each clock pulse input thereto of a one-sequence clock signal;
b) a flip-flop which inverts its state responsive to the input of a predetermined number of said clock pulses to said addressing means; and
c) two memory means each having a capacity of plural bits, said two memory means having a common data input, different addresses successively designated by said addressing means being used as a common address input of said two memory means, characterised in that:
   said two memory means are adapted to cyclically input data at said different addresses designated by said addressing means or output data at said different addresses designated, and said two memory means are arranged such that one is placed in a read state while the other is placed in a write state depending on the state of said flip-flop.

### BRIEF DESCRIPTION OF THE DRAWINGS

In the accompanying drawings:
Fig. 1 is a schematic view illustrating a conventional shift register;
Fig. 2 is a block diagram showing a basic concept of a memory device to which the present invention applies;
Fig. 3 is a circuit diagram illustrating further detail of a memory device based on the configuration shown in Fig. 2;
Fig. 4 is a circuit diagram illustrating an embodiment of the invention based on the configuration shown in Fig.2;
Fig. 5 is block diagram showing another concept of a memory device wherein the memory device has a function to repeatedly read the same data;
Fig. 6 is a circuit diagram illustrating in further detail the memory device based on the configuration shown in Fig. 5; and
Fig. 7 is a timing chart showing the operation of the memory device shown in Fig. 6.

Figures 1-3 and 5-7 are included for explanatory purposes.

### DETAILED DESCRIPTION OF THE INVENTION

The present invention will be described in detail in connection with preferred embodiments with reference to attached drawings.

Initially, referring to Fig. 2, there is shown, in a block form, a basic concept of a memory device. The memory device shown is configured so that addresses of a memory means 20 for storing input data therein are designated by an addressing means 30, thus effecting write and read operations of data. This addressing means 30 has a function to cyclically designate addresses of the memory means 20 so that the same value of the address is not designated during one cycle. For instance, when the number of the designation is equal to N, the addressing means 30 functions as an mod-N counter (defined as a counter having N states in the positional notation) which is decremented by one from N-1 per each clock pulse to return to the value of N-1 for a second time when the count value is equal to zero. The memory means 20 has a function to store data into a memory area assigned to an address designated by the addressing means 30 and/or read the data therefrom. For the memory means 20, e.g., dynamic RAM of 64K bit configuration may be used.

The memory device thus configured operates as follows. First, an address is designated by using the addressing means 30 to store data into a memory area assigned to the designated address. In the next step, by allowing the addressing means 30 to circulate so as to designate the same address in the same order, data is read from the concerned memory area, thus making it possible to fetch the same data previously stored therefrom. Thus, the memory device functions as a shift register.

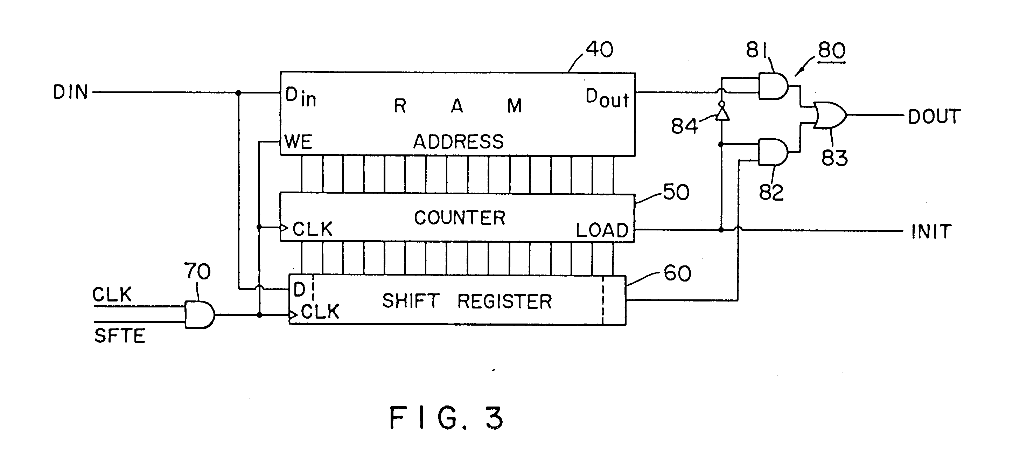

Fig. 3 is a circuit diagram base on the configuration shown in Fig. 2. This memory device comprises a RAM 40, a counter 50 for designating write and read addresses of the RAM 40 one by one per each clock pulse, a shift register 60 for setting a count value to the counter, a control circuit 70 for effecting control of the entirety of the memory circuit, and a selector 80.

In this circuit the RAM 40 is comprised of a dynamic RAM of 64K bit configuration. The RAM 40 is provided with 16 address lines, thus making it possible to write data into a memory area assigned to an address determined by the selection of the address lines or read it from the memory area assigned to the address. To perform this function, the RAM 40 is provided with a write enable (WE) terminal, a data input (Din) terminal and a data output (Dₒᵤₜ) terminal.

The counter 50 counts down one by one per each clock pulse from a designated value less than (2¹⁶⁻1). After the count value reaches zero, the counter 50 repeatedly counts down from the value of n. In this counter 50, the value of n is determined by 16 set inputs.

The shift register 60 is configured as a sixteen stage shift register for setting the value of n wherein outputs of their stages are set inputs of the counter, respectively.

The control circuit 70 is comprised of an AND gate to which a clock (CLK) signal and shift enable (SFTE) signal are input. An output of the control circuit 70 is input to a CLK terminal of the shift register 60, a CLK terminal of the counter 50 and a WE (write enable) terminal of the RAM 40. When the SFTE signal is at high level, the CLK signal is delivered to the above-mentioned circuit components from the control circuit 70.

The selector 80 comprises an AND gate 81 to which a Dₒᵤₜ output of the RAM 40 and a signal obtained by inverting an initialization (INIT) signal using an inverter 84 are input, an AND gate 82 to which the INIT signal and an output of the shift register 60 are input, and an OR gate to which outputs from the two AND gates are input. An output of the OR gate 83 is output as an output of the entire circuit. The INIT signal is also input to a LOAD terminal of the counter 50.

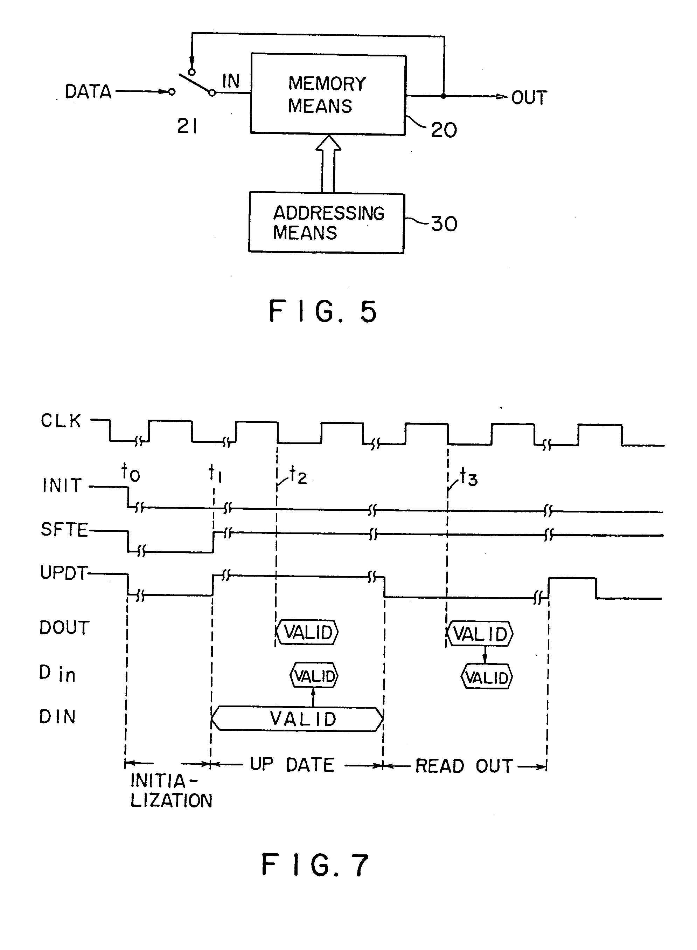

Fig. 4 is circuit diagram illustrating an embodiment obtained by improving the configuration shown in Fig. 2.

In this embodiment, the memory device comprises two memory means 20a and 20b subject to addressing by a common addressing means represented by the same reference numeral 30 as in the circuit shown in Fig. 2. The memory device further comprises a flip-flop 31 which inverts its state when a designated value becomes zero in response to the completion of a single-cyclic clock signal. An output signal of the flip-flop 31 is delivered to a write enable (WE) terminal of the memory means 20a through an inverter 35 and is directly delivered to a write enable (WE) terminal of the memory means 20b so that signals delivered to the WE terminals of the memory means 20a and 20b are opposite to each other in their logical states. To the memory means 20a and 20b, data is commonly input. An output of the memory means 20a and an inverted signal of the output signal from the flip-flop 31 are input to an AND gate 32. An output of the memory means 20b and the output signal from the flip-flop 31 are input to an AND gate 33. Two outputs of the AND gates 32 and 33 are input to an OR gate 34. Thus, output data is output from memory means placed in the write-disabled state in accordance with the function given by the circuit comprising the inverter 35, the AND gates 32 and 33 and the OR gate 34.

The operation of the embodiment shown in Fig. 4 will be described below.

Assuming now that the output of the flip-flop 31 represents logical "1" " in an initial state, the memory means 20b is in write-disabled state and the memory means 20a is in write enabled state. When an address is designated by the addressing means 30, data is read from the memory means 20b one by one per each clock pulse and the data thus read is output through the AND gate 33 and the OR gate 34. At this time, data is written into a memory area assigned to a designated address of the memory means 20a. The output of the memory means 20a is disallowed because the AND gate 32 is in disable state.

Subsequently, when the address designation value is successively decremented and then reaches to zero, the address designation value becomes equal to N-1 for a second time and at the same time an output of the flip-flop 31 is inverted so that its logical state becomes "0". As a result, data is read from the memory means 20a and data is written into the memory means 20b.

This embodiment can eliminate the possibility of discontinuity of data which would occur in the embodiment shown in Fig. 2 and realize substantially the same memory device as a 2N state shift register.

Referring to Fig. 5, there is shown for explanatory purposes a further memory device wherein memory means represented by reference numeral 20' and the addressing means 30 are provided in the same manner as in the configuration shown in Fig. 2. In this embodiment, the addressing means 30 is basically identical to that in the configuration shown in Fig. 2, but the memory means 20' differs from that in the latter in that it has a function to write data while reading it, i.e., effect so-called read modify write operation. An output of the memory means 20' is fetched therefrom and at the same time the output is fed back to the input side of the memory means 20' to again input the output thus fed back to the memory means through a switch means 21. The switch means 21 may be comprised of e.g. a gate circuit for selecting a new data input or a re-input of memory contents.

In the memory device thus configured, by allowing the addressing means 30 to cyclically designate the same value in the same order during each cycle and by setting the switch means 21 so as to rewrite an output of the memory means 20', it is possible to repeatedly fetch a series of the same data per each cycle. Further, by changing the number of addresses assigned to memory areas in the memory means 20' designated by the addressing means 30, the memory device in this embodiment can function as a shift register having an arbitrary number of stages. In addition, when the switch means 21 is set to the DATA input, the memory device in this embodiment has substantially the same configuration and operation as in the device shown in Fig. 1.

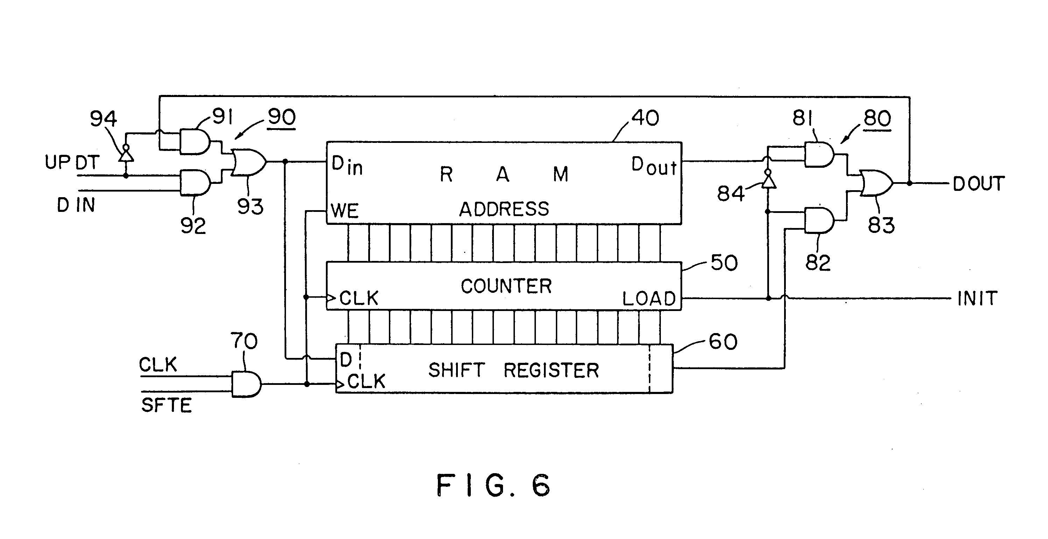

Fig. 6 is a circuit diagram illustrating the detail of the configuration shown in Fig. 5.

This memory device shown is provided, as the same circuit components as those in the circuit shown in Fig. 3, with the RAM 40, the counter 50 for designating write and read addresses of the RAM 40 one by one per each clock pulse, the shift register 60 for setting a count value to the counter 50, the control circuit 70 for effecting the entirety of the circuit, and the selector 80, and it is provided with a selector 90 newly added.

The configuration and the operation of the RAM 40, the shift register 60, the control circuit 70 and the selector 80 have been previously described in connection with the embodiment shown in Fig. 3. Therefore, their explanation will be omitted and the configuration and the operation of the selector 90 will now be mainly referred to here.

The selector 90 comprises an AND gate 92 to which an update (UPDT) signal and an entire circuit input Dᵢₙ areinput, an AND gate 91 to which a signal obtained by inverting the UPDT signal using an inverter 90 and an output of the selector 80 are input, and an OR gate 93 to which outputs from the two AND gates are input. An output of the OR gate 93 is input to an input Dᵢₙ of the RAM 40 and a D terminal of the shift register 60.

The operation of the memory device thus configured will be described with reference to a timing chart shown in Fig. 7.

First, the UPDT signal is set at H level to input store data into the shift register 60, i.e. data indicative of a count start number n. At this time, a SFTE signal of H level is input to the control circuit 60 to input 16 clock pulses so that the data indicative of the count start number is stored into the shift register 60. Thus, the counter start number n is stored into the shift register 60 in a binary form. Accordingly, when an INIT signal of H level is input to the LOAD terminal of the counter 50, the count start number n is set to the counter 50. Then, when the INIT signal shifts to L level, the data indicative of the count start number n is maintained in the counter 50 as it is. The initialization is thus completed. Accordingly, when the INIT signal and the SFTE signal are respectively set at L level at time to, the initialized condition is maintained.

Then, for allowing this memory device to function as a device identical to ordinary shift registers, this memory device operates so as to output SFTE signal of H level from the control unit 70 and to output UPDT signal of H level from the selector 90 (time ti in Fig. 7). As a result, the DIN input becomes valid because an output of the AND gate 92 shifts to H level. In this embodiment, the RAM 40 effects the read modify write operation as previously described. Accordingly, the data read output Dₒᵤₜ becomes valid at the time of a falling of the CLK signal at time t₂ in Fig. 7, with the result that the write input Dᵢₙ becomes valid within a portion of the valid period of the data read output. Accordingly, when data of N bits to be stored as the Dᵢₙ signal is input, this N bit data is delivered to the Dᵢₙ input terminal of the RAM 40 via the AND gate 92 and the OR gate 93. At this time, since the SFTE signal is placed in H level, the CLK signal is input from the control circuit 70 to the CLK terminal of the counter 50 and the WE terminal of the RAM 40. Accordingly, data is written, bit by bit, into memory areas assigned to respective addresses of the RAM 40 corresponding to count values output from the counter 50. When the count value of the counter 50 is equal to zero, the count value represents n for a second time at timing of the next clock pulse. At this time, the contents stored in the RAM 40 are output as the data read output D_{ou;} irrespective of the fact that any data is input as the DIN. Namely, for a time period during which a count value of the counter 50 circulates, data is fetched in order of storing data in the previous cycle. Thus, this memory device functions as an N (N = n + 1) stage shift register which effects FIFO operation.

When data input to the DIN terminal at the time of reading is valid data, the content of the RAM 40 is replaced by this valid data and the valid data thus replaced is read in the next count cycle. In contrast, when the input data is invalid or null data, the content of the RAM 40 becomes invalid.

The operation for repeatedly reading the same data will now be described.

Initially, as previously described, the UPDT signal and the SFTE signal are set at H level to input valid data from the DIN terminal to store it into the RAM 40. When a count value of zero is reached, the UPDT signal is set at L level. Thus, an input to the AND gate 91 shifts to H level. As a result, the DOUT signal is input to the Dᵢₙ terminal. Accordingly, since the Dᵢₙ input becomes valid for a time period during which the DOUT output is valid as indicated by time t₃ in Fig. 7, it is possible to store the memory content of the RAM 40 into the RAM 40 for a second time. Thus, the same memory contents can be repeatedly fetched.

To realize such a memory device , it is sufficient to provide 8 pins for DIN, DOUT, CLK, SFTE, INIT, UPDT, power supply and ground. This memory device can be configured as e.g. a single-in- line package provided with lead wires for the above-mentioned terminals. In addition, this memory device has a circuit configuration such that a simple circuit e.g. a counter is only added to RAM. As a result, there is no possibility that an area for circuit components is increased, thus facilitating realization of integrated circuit.

In the above-described embodiments, the counter which successively counts down one by one per each clock pulse is used for the addressing means. Instead, there may be employed a counter to successively count up one by one or a counter which does not necessarily output continuous values, but outputs discrete different values during each cycle. The essential requirement for the addressing means is to have a function as state transition means capable of designating non-used write or read addresses of memory means without repeatedly addressing the same value during each cycle. In view of this, e.g. a random number generator which does not generate the same number may be used. When such a random number generator is employed, it is required to reconstruct read data on the basis of designated addresses.

In the above-mentioned embodiment, the shift register is used to set the number of stages required for the counter operation to the counter. According to use, there are instances where there is no need to change the depth as the memory device. In these instances, the number of stages required for the counter operation may be set by ROM. In addition, the shift register employed in the above-mentioned embodiment is of the serial setting type, but shift registers of the parallel setting type may be used.

Further, by connecting a plurality of circuits each employed in the above-mentioned embodiments in series, i.e., by connecting DOUT terminal to DIN terminal of the next stage circuit, it is possible to provide a large number of stages as desired.

In the above-mentioned embodiment, the counter has the same operation mode at the time of writing of data as that at the time of reading of data. Accordingly, each memory device including such a counter functions as a FIFO memory. In addition to this, if addressing at the time of reading is carried out in order opposite to that at the time of writing, each memory device can be used as a FILO memory. For this purpose, a reversible shift register may be used for the shift register.

As described in detail, the memory device according to the present invention is provided with memory means capable of storing data into a memory area assigned to an address designated or reading it therefrom, and addressing means for designating address values different from each other during each cycle. Accordingly, by selecting the number of address values designated by the addressing means, it is possible to provide a memory device having an arbitrary number of stages which has a capacity less than that of the memory means.

Further, by employing the memory means capable of effecting read and write operations at the same time to deliver its output back to the input side thereof for a second time, it is possible to provide a memory device having an arbitrary number of stages which is capable of repeatedly outputting the same data.

In addition, by employing two memory means having the common data input and the common addressing input, and the flip-flop which inverts its state in response to the completion of addressing singal corresponding to one cycle having N clock pulses from the addressing means to input an output of the flip-flop to the write enable terminals of the two memory means so that logical states at the write enable terminals are opposite to each other, it is possible to provide a 2N memory device having an arbitrary number of stages.

## Claims

1. A memory device comprising:
a) addressing means (30) for cyclically designating different values as addresses for input and output of data per each clock pulse input thereto of a one-sequence clock signal;
b) a flip-flop (31) which inverts its state responsive to the input of a predetermined number of said clock pulses to said addressing means (30); and
c) two memory means (20a,20b) each having a capacity of plural bits, said two memory means (20a, 20b) having a common data input, different addresses successively designated by said addressing means (30) being used as a common address input of said two memory means;
characterised in that:
said two memory means are adapted to cyclically input data at said different addresses designated by said addressing means (30) or output data at said different addresses designated, and said two memory means (20a, 20b) are arranged such that one is placed in a read state while the other is placed in a write state depending on the state of said flip-flop (31

2. A memory device as set forth in claim 1, wherein said memory means (20) is provided with switch means (21) to selectively input feedback data from the output of the memory device or new data.

3. A memory device as set forth in claim 2, wherein said switch means (21) is comprised of a gate circuit which operates in response to a switching signal.

4. A memory device as set forth in any of claims 1 to 3, wherein said addressing means (30) is comprised of a random number generator circuit which does not repeatedly generate the same value during each cycle.

5. A memory device as set forth in any of claims 1 to 3, wherein said addressing means is comprised of a presettable counter (50) to output a value successively increasing or decreasing one by one.

6. A memory device as set forth in claim 5, wherein said counter (50) is arranged to output a discrete value.

7. A memory device as set forth in claim 5 or 6, wherein said counter (50) is connected to a count value holding means to designate a count value to be outputted.

8. A memory device as set forth in claim 7, wherein said count value holding means is comprised of a shift register (60).

9. A memory device as set forth in claim 7, wherein said count value holding means is comprised of read only memory device.

## Patentansprüche

1. Speichervorrichtung umfassend:
a) eine Adressierungseinrichtung (30) zur zyklischen Bestimmung verschiedener Werte als Adressen zur Eingabe und Ausgabe von Daten bei jeder Taktimpulseingabe eines Einzelsequenz-Taktsignals;
b) ein Flip-Flop (31), das seinen Zustand als Antwort auf die Eingabe einer vorbestimmten Anzahl von Taktimpulsen in die Adressierungseinrichtung (30) ändert; und
c) zwei Speichereinrichtungen (20a, 20b), wovon jede eine Kapazität von mehreren Bits hat, wobei die zwei Speichereinrichtungen (20a, 20b) einen gemeinsamen Dateneingang haben, wobei verschiedene Adressen, die sukzessiv durch die Adressierungseinrichtung (30) bestimmt werden, als eine gemeinsame Adresseneingabe der zwei Speichereinrichtungen benutzt werden;
dadurch gekennzeichnet, daß:
die zwei Speichereinrichtungen angepaßt sind, um zyklisch Daten an den durch die Adressierungseinrichtung (30) bestimmten verschiedenen Adressen einzugeben oder Daten an den verschiedenen bestimmten Adressen auszugeben, und daß die zwei Speichereinrichtungen (20a, 20b) so angeordnet sind, daß sich eine in einem Lesezustand, während sich die andere in einem Schreibzustand befindet, abhängig vom dem Status des Flip-Flops (31).

2. Speichervorrichtung gemäß Anspruch 1, dadurch gekennzeichnet, daß die Speichereinrichtung (20) mit einer Schaltereinrichtung (21) versehen ist, um selektiv rückgekoppelte Daten von dem Ausgang der Speichervorrichtung oder neue Daten einzugeben.

3. Speichervorrichtung gemäß Anspruch 2, dadurch gekennzeichnet, daß die Schaltereinrichtung (21) eine Gatterschaltung umfaßt, die ansprechen auf auf ein Schaltsignal arbeitet.

4. Speichervorrichtung gemäß einem der Ansprüche 1 bis 3, dadurch gekennzeichnet, daß die Adressierungseinrichtung (30) aus einer Zufallszahlengeneratorschaltung besteht, die innerhalb jedes Zyklus nicht wiederholt denselben Wert erzeugt.

5. Speichervorrichtung gemäß einem der Ansprüche 1 bis 3, dadurch gekennzeichnet, daß die Adressierungseinrichtung (30) aus einem vorsetzbaren Zähler (50) besteht, um einen Wert auszugeben, der sukzessiv schrittweise größer oder kleiner wird.

6. Speichervorrichtung gemäß Anspruch 5, dadurch gekennzeichnet, daß der Zähler (50) so eingerichtet ist, daß er einen diskreten Wert ausgibt.

7. Speichervorrichtung gemäß Anspruch 5 oder 6, dadurch gekenzeichnmet, daß der Zähler (50) mit einer Zählerstandhalteeinrichtung verbunden ist, um einen auszugebenden Zählerstand zu bezeichnen.

8. Speichervorrichtung gemäß Anspruch 7, dadurch gekennzeichnet, daß die Zählerstandhalteeinrichtung aus einem Schieberegister (60) besteht.

9. Speichervorrichtung gemäß Anspruch 7, dadurch gekennzeichnet, daß die Zählerstandhalteeinrichtung einem Nur-Lese-Speicher umfaßt.

## Revendications

1. Dispositif de mémoire comportant:
a) un dispositif d'adressage (30) destiné à désigner de façon cyclique différentes valeurs comme adresses pour l'entrée et la sortie de données à chaque impulsion d'horloge d'un signal d'horloge mono-séquence y entrant;
b) une bascule (31) qui change d'état en réponse à l'entrée d'un nombre prédéterminé desdites impulsions d'horloge sur ledit dispositif d'adressage (30); et
c) deux composants de mémoire (20a, 20b) ayant chacun une capacité de plusieurs bits, lesdits deux composants de mémoire (20a, 20b) ayant une entrée de données commune, des adresses différentes désignées successivement par ledit dispositif d'adressage (30) étant utilisées comme entrée d'adresse commune desdits deux composants de mémoire;
caractérisés en ce que:
lesdits deux composants de mémoire sont adaptés pour recevoir en entrée des données de façon cyclique auxdites adresses différentes désignées par ledit dispositif d'adressage (30) ou pour fournir en sortie des données auxdites adresses différentes désignées, et lesdits deux composants de mémoire (20a, 20b) sont disposés de sorte que l'un est placé dans l'état de lecture tandis que l'autre est placé dans l'état d'écriture selon l'état de ladite bascule (31).

2. Dispositif de mémoire comme présenté dans la revendication 1, caractérisé en ce que ledit composant de mémoire (20) est fourni avec un dispositif de commutation (21) afin d'appliquer en entrée de façon sélective les données en retour provenant de la sortie du dispositif de mémoire ou de nouvelles données.

3. Dispositif de mémoire comme présenté dans la revendication 2, caractérisé en ce que ledit dispositif de commutation (21) est constitué d'un circuit à porte qui fonctionne en réponse à un signal de commutation.

4. Dispositif de mémoire comme présenté dans l'une quelconque des revendications 1 à 3, caractérisé en ce que ledit dispositif d'adressage (30) est constitué d'un circuit générateur de nombres aléatoires qui ne génère pas de façon répétitive la même valeur durant chaque cycle.

5. Dispositif de mémoire comme présenté dans l'une quelconque des revendications 1 à 3, caractérisé en ce que ledit dispositif d'adressage est constitué d'un compteur pré-positionna- ble (50) destiné à fournir en sortie une valeur augmentant ou diminuant successivement d'une unité à la fois.

6. Dispositif de mémoire comme présenté dans la revendication 5, caractérisé en ce que ledit compteur (50) est disposé de façon à fournir en sortie une valeur discrète.

7. Dispositif de mémoire comme présenté dans la revendication 5 ou dans la revendication 6, caractérisé en ce que ledit compteur (50) est relié à un dispositif de maintien de la valeur de comptage destiné à désigner une valeur de comptage devant être disponible en sortie.

8. Dispositif de mémoire comme présenté dans la revendication 7, caractérisé en ce que ledit dispositif de maintien de la valeur de comptage est constitué d'un registre à décalage.

9. Dispositif de mémoire comme présenté dans la revendication 7, caractérisé en ce que ledit dispositif de maintien de la valeur de comptage est constitué d'un dispositif de mémoire à lecture seule.
